(19) Europäisches Patentamt
European Patent Office
Office européen des brevets

(11) EP 1 901 364 A1

(12) **EUROPEAN PATENT APPLICATION**
published in accordance with Art. 153(4) EPC

(43) Date of publication:
**19.03.2008 Bulletin 2008/12**

(21) Application number: **06767708.8**

(22) Date of filing: **30.06.2006**

(51) Int Cl.:
***H01L 51/50*** *(2006.01)* ***C09K 11/06*** *(2006.01)*

(86) International application number:
**PCT/JP2006/313100**

(87) International publication number:
**WO 2007/004563 (11.01.2007 Gazette 2007/02)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **06.07.2005 JP 2005197940**

(71) Applicant: **IDEMITSU KOSAN CO., LTD.**
**Tokyo 100-8321 (JP)**

(72) Inventors:
- **MATSUURA, Masahide**
  **Chiba 2990293 (JP)**
- **NAGASHIMA, Hideaki**
  **Chiba 2990293 (JP)**
- **IKEDA, Hidetsugu**
  **Chiba 2990293 (JP)**
- **NAKAMURA, Hiroaki**
  **Chiba 2990293 (JP)**

(74) Representative: **Gille Hrabal Struck Neidlein Prop Roos**
**Patentanwälte**
**Brucknerstrasse 20**
**40593 Düsseldorf (DE)**

# (54) ORGANIC ELECTROLUMINESCENT DEVICE

(57) An organic electroluminescent device (1) including: an anode (10) and a cathode (30), and an emitting layer (20) including an anode-side region (22), an internal region (24) and cathode-side region (26) provided between the anode (10) and the cathode (30); each of the regions (22), (24) and (26) including a host compound of an organic material and a dopant of a metal complex containing a heavy metal and exhibiting light emitting properties originated from a triplet state; the dopant concentration of the internal region (24) being higher than the dopant concentrations of the anode-side region (22) and the dopant concentration of the cathode-side region (24).

FIG. 1

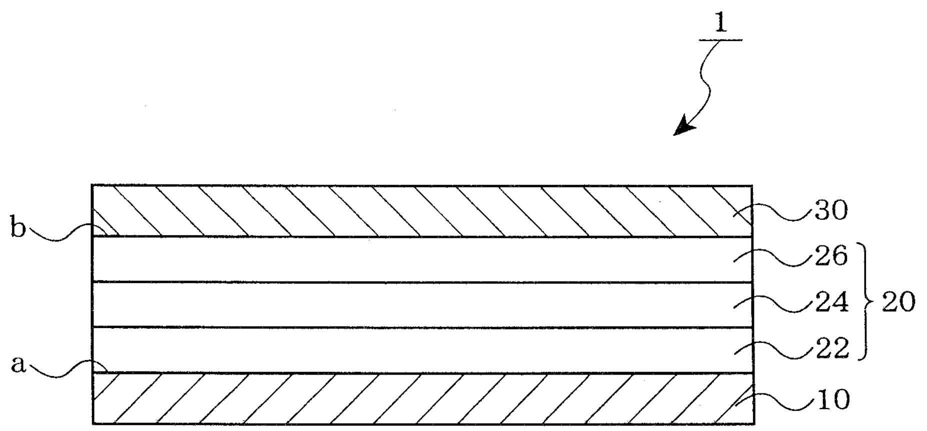




Printed by Jouve, 75001 PARIS (FR)

## Description

### TECHNICAL FIELD

The invention relates to an organic electroluminescent (EL) device. In detail, it relates to an organic electroluminescent device having a high luminous efficiency.

### TECHNICAL BACKGROUND

An organic EL device using an organic material is a promising solid-state emitting type inexpensive and large full-color display device, and has been extensively developed.
In general, the organic EL device includes an emitting layer and a pair of opposite electrodes holding the emitting layer therebetween. When an electric field is applied between electrodes of an organic EL device, electrons are injected from a cathode and holes are injected from an anode. The electrons recombine with the holes in an emitting layer to produce an excited state, and energy is emitted as light when the excited state deactivates to the ground state. The EL device emits light by utilizing this phenomenon.
Various configurations have been known as the configuration of the organic EL device. For example, patent document 1 discloses an organic EL device having a device configuration including indium tin oxide (ITO)/hole transporting layer/emitting layer/cathode. The patent document 1 discloses using an aromatic tertiary amine as the material for the hole transporting layer. This device configuration achieves a high luminance of several hundred cd/$m^2$ at an applied voltage of 20 V or less.
Non-patent document 1 has reported that a luminous efficiency of about 40 1m/W or more is achieved at a luminance equal to or less than several hundred cd/$m^2$ by using an iridium complex (phosphorescent dopant) for the emitting layer as a dopant.
However, since most phosphorescent organic EL devices emit green or red light, an increase in the number of colors and an increase in the blue luminous efficiency have been demanded. In particular, a blue device configuration with a luminous quantum efficiency of 5% or more is rare.
When applying an organic EL device to a flat panel display or the like, the organic EL device is required to exhibit an improved luminous efficiency and reduced power consumption. However, the device configuration disclosed in the non-patent document 1 has a disadvantage that the luminous efficiency significantly decreases accompanying an increase in luminance. Therefore, it is difficult to reduce the power consumption of the flat panel display.
Patent document 2 discloses technology in which a concentration gradient is utilized for an emitting layer of an organic EL device. The patent document 2 discloses an organic EL device using a heavy metal complex Irppy in Example 1 and Comparative Example 1. The device of Example 1 has a configuration in which a portion other than the emitting layer containing the complex is doped or formed of a mixed layer. The external quantum efficiency merely increased from 15% to 16%. The patent document 2 discloses only an application of Irppy in green region, but does not disclose an organic EL device which emits blue light using a heavy metal complex.
Patent document 3 also discloses technology which improves performance by utilizing a concentration gradient. However, the technology disclosed in the patent document 3 merely creates a simple concentration gradient between the anode side and the cathode side of the emitting layer.
[Patent document 1] JP-A-63-295695
[Patent document 2] JP-A-2005-100767
[Patent document 3] US-2005-0046337 A1
[Non-patent document 1] T. Tsutsui et. al., Jpn. J. Appl. Phys. Vol. 38 (1999), pp. L1502 to L1504
An object of the invention is to provide an organic EL device, particularly a blue organic EL device which exhibits high current efficiency or high luminous efficiency.

### SUMMARY OF THE INVENTION

A dopant used for the emitting layer is required to exhibit properties of injecting carriers into the emitting layer and light emitting properties. The inventors of the invention have conducted extensive studies on improvement of the light emitting properties of a phosphorescent organic EL device by separating these properties. As a result, the inventors have found that a specific dopant concentration range exhibits excellent carrier injecting properties and a specific dopant concentration range exhibits excellent light emitting properties, and that the light emitting properties can be improved by separately providing these concentration ranges, whereby a device exhibiting a more excellent performance can be obtained. This finding has led to the completion of the invention.
According to the invention, the following organic EL device is provided.

1. An organic electroluminescent device comprising: an anode and a cathode, and an emitting layer comprising an anode-side region, an internal region and cathode-side region provided between the anode and the cathode; each of the regions comprising a host compound of an organic material and a dopant of a metal complex containing a heavy metal and exhibiting light emitting properties originated from a triplet state; the dopant concentration of the internal region being higher than the dopant concentrations of the anode-side region and the dopant concentration of the cathode-side region.

2. The organic electroluminescent device according to 1 wherein the triplet energy gap of the metal complex is 2.65 eV or more.

3. The organic electroluminescent device according to 1 or 2 wherein the dopant concentration of the anode-side region and the dopant concentration of the cathode-side region are different.

4. The organic electroluminescent device according to 3 wherein the dopant concentration of the cathode-side region is higher than the dopant concentration of the anode-side region.

5. The organic electroluminescent device according to any one of 1 to 4 wherein the dopant concentration of the internal region is 30 wt% or less.

6. The organic electroluminescent device according to any one of 1 to 5 wherein the difference between the dopant concentration of the internal region, and the dopant concentration of the anode-side region or the cathode-side region having a lower dopant concentration is 3 to 15 wt%.

7. The organic electroluminescent device according to any one of 1 to 6 wherein the dopant concentration discontinuously changes between the anode-side region, the internal region, and the cathode-side region.

8. The organic electroluminescent device according to any one of 1 to 7 wherein the anode-side region and the cathode-side region are regions with a thickness of 5 nm or more from the interface between the anode and the cathode, respectively.

9. The organic electroluminescent device according to any one of 1 to 7 further comprising a hole transporting layer provided between the emitting layer and the anode, or an electron transporting layer provided between the emitting layer and the cathode;
the anode-side region and the cathode-side region being regions with a thickness of 5 nm or more from the interface between the hole transporting layer or the electron transporting layer and the emitting layer, respectively.

10. The organic electroluminescent device of any one of 1 to 9 emitting light containing a wavelength component of 350 nm or more and 450 nm or less.

The invention provides an organic EL device which exhibits a high current efficiency or high luminous efficiency, particularly an organic EL device emitting blue light.

The device of the invention has a higher efficiency than a known device even in the case where the average concentration in all region of the emitting layer is lower than the average concentration in the emitting layer with a uniform concentration of the known device. As a result, higher efficiency while reducing the consumption of complexes is realized.

BRIEF DESCRIPTION OF THE DRAWINGS

FIG. 1 is a cross-sectional view illustrating one embodiment of the organic EL device according to the invention.

FIG. 2 is a view showing an optically excited emission spectrum for explaining a method for calculating a triplet energy gap.

FIG. 3 is a cross-sectional view illustrating another embodiment of the organic EL device according to the invention.

BEST MODE FOR CARRYING OUT THE INVENTION

Embodiments of the invention are described below with reference to the drawings.
FIG. 1 is a cross-sectional view illustrating one embodiment of an organic EL device according to the invention.
An organic EL device 1 includes an anode 10, an emitting layer 20, and a cathode 30. The emitting layer 20 includes a layer-like anode-side region 22, internal region 24, and cathode-side region 26.

The thickness of the entire emitting layer 20 is usually 15 nm to 500 nm. The thicknesses of the regions 22, 24, and 26 are preferably 5 nm or more, more preferably 5 nm to 100 nm, and still more preferably 5 nm to 30 nm. A continuous film is necessary for a layer which has a surface-emitting function. If the thickness of the film is less than 5 nm, the film may not be provided with the surface-emitting function, whereby the light emitting properties may become nonuniform. It is preferable that the anode-side region 22 and the cathode-side region 24 be regions with a thickness of 5 nm or more from the interfaces a and b with the anode 10 and the cathode 30, respectively.

Each of the regions 22, 24, and 26 includes a host compound formed of an organic material, and a dopant

formed of a metal complex containing a heavy metal and exhibiting light emitting properties originated from the triplet state. The triplet energy gap of the metal complex is preferably 2.65 eV or more.
In the invention, the emitting layer refers to an organic layer including the above dopant.

In this embodiment, the dopant concentration of the internal region 24 is higher than the dopant concentration of the anode-side region and the dopant concentration of the cathode-side region. The dopant concentration of each region refers to the average dopant concentration thereof. The dopant concentration of the internal region is higher than the dopant concentration of the anode-side region and the dopant concentration of the cathode-side region in an amount of preferably 2 wt% or more, and still more preferably 4 wt% or more.

The dopant concentration of the anode-side region 22 and the dopant concentration of the cathode-side region 26 may be the same or different. The dopant concentration of the anode-side region 22 and the dopant concentration of the cathode-side region 26 may differ in an amount of 1 wt% or more.
When the dopant concentration of the anode-side region 22 and the dopant concentration of the cathode-side region 26 differ, it is preferable that the dopant concentration of the cathode-side region 26 be higher than the dopant concentration of the anode-side region 24 in order to improve the carrier injecting properties.

The dopant concentration of each of the regions 22, 24, and 26 is preferably 0.1 to 30 wt%, and still more preferably 0.1 to 20 wt%. The dopant concentrations of the anode-side region 22 and the cathode-side region 26 are usually 1 wt% to 15 wt%, and the dopant concentration of the internal region 24 is usually 5 wt% to 30 wt%. The dopant concentrations of the anode-side region 22 and the cathode-side region 26 are preferably 3 wt% to 10 wt%, and the dopant concentration of the internal region 24 is preferably 8 wt% to 20 wt%.

It is preferable that the difference between the dopant concentration of the internal region 24, and the dopant concentration of the anode-side region 22 or the cathode-side region 26 having a lower dopant concentration be 3 wt% to 15 wt%.

It is preferable that the dopant concentration discontinuously change between the anode-side region 22, the internal region 24, and the cathode-side region 26. The term "discontinuously" used herein means that the dopant concentration discontinuously changes at the interface between two regions in an amount of 3 wt% or more per 10 angstroms (a difference of 3 wt% or more exists between two points at a distance of 10 angstroms).

The dopant is formed of a metal complex containing a heavy metal. The triplet energy gap of the metal complex is preferably 2. 65 eV or more. Specifically, the organic EL device according to the invention is a phosphorescent organic EL device. The organic EL device 1 more preferably emits blue to green light. In this case, a highly efficient emission is realized by allowing the triplet state to contribute to "blue to green emission". The blue to green light has a peak wavelength of at least about 420 to 530 nm.

The triplet energy gap ($Eg^T$) may be calculated by measuring the optically excited emission spectrum of the metal complex at 77K, and determining the shortest wavelength.
In the invention, the triplet energy gap ($Eg^T$) is calculated by converting energy at the wavelength λo, as shown in FIG. 2. A line tangent to the shorter-wavelength component of the optically excited emission spectrum shown in FIG. 2 is drawn to determine the wavelength λo. The triplet energy gap ($Eg^T$) is determined based on the wavelength λo using the conversion expression $Eg^T$ (eV) = 1239.85/λo.

The triplet energy gap ($Eg^T$) may be measured using a known phosphorescence measurement method (e.g. method described in "The World of Photochemistry" (edited by The Chemical Society of Japan, 1993), around page 50). In more detail, the organic material is dissolved in a solvent (sample 10 micromol/l, EPA (diethyl ether:isopentane:ethanol = 5:5:2 (volume ratio)) to obtain a phosphorescence measurement sample. After cooling the sample placed in a quartz cell to 77K, excitation light is applied to the sample, and the resulting phosphorescence is measured with respect to the wavelength. As shown in FIG. 2, a line tangent to the rise of the phosphorescence spectrum is drawn on the shorter wavelength side, and the value obtained by converting the wavelength λo into an energy value is taken as the triplet energy gap ($Eg^T$).

The device 1 preferably emits light containing a wavelength component of 350 nm or more and 450 nm or less. If the device 1 emits light containing a wavelength component of 350 nm or more and 450 nm or less, blue light can be obtained in view of chromaticity.

FIG. 3 is a cross-sectional view illustrating another embodiment of the organic EL device according to the invention.
An organic EL device 2 is the same as the organic EL device according to the above embodiment except that the organic EL device 2 includes a hole transporting layer 40 provided between the emitting layer 20 and the anode 10 and an electron transporting layer 50 provided between the emitting layer 20 and the cathode 30. The properties of injecting carriers into the emitting layer are improved by the hole transporting layer 40 and the electron transporting layer 50, whereby the current efficiency (L/J efficiency) can be increased.

The organic EL device according to the invention may include another intermediate layer, and may have the following configurations, for example.

(1) Anode/hole transporting layer/emitting layer/cathode
(2) Anode/hole injecting layer/hole transporting layer/emitting layer/cathode
(3) Anode/hole transporting layer/emitting layer/electron transporting layer/electron injecting layer/cathode
(4) Anode/hole injecting layer/hole transporting layer/emitting layer/electron transporting layer/electron injecting layer/cathode

The above configuration (3) or (4) is preferable. The members are stacked on a substrate in the above order or in the reverse order. It is preferable that at least one of the anode and the cathode be formed of a transparent or translucent substance in order to efficiently outcouple light from the emitting layer.
In this embodiment, it is preferable that the anode-side region 22 and the cathode-side region 24 be regions with a thickness of 5 nm or more from the interface between the hole transporting layer 40 or the electron transporting layer 50 and the emitting layer 20, respectively.
The method of forming each of the layers 10 to 40 of the organic EL device 1 is not particularly limited. The layers 10 to 40 may be formed using a known organic EL device fabrication method. In more detail, each layer may be formed by vacuum deposition, casting, applying, spin coating, or the like.
In vacuum deposition, the concentration may be determined by adjusting the deposition rate of the host compound of the emitting layer and the deposition rate of the dopant.
In wet film formation such as casting, applying, or spin coating, the complex concentration in the emitting layer may be determined by the weight ratios of the host compound and the dopant in a film formation solution.
As the method of creating a concentration gradient, the deposition temperature may be changed or the deposition rate may be changed by opening/closing a shutter when using vacuum deposition, for example. When using the applying method, a concentration gradient may be formed by using an ink solution in which the host material and the complex corresponding to a desired concentration are mixed. When using the casting method, a thin film with a concentration gradient may be formed by adjusting the balance between the precipitation rate and the drying rate. A concentration gradient may be achieved by these methods. Note that the method of creating a concentration gradient is not limited to these methods.
In the device configuration according to the invention, since the hole barrier is smaller than the electron barrier so that the hole injecting properties are higher than the electron injecting properties, the dopant concentration of the cathode-side region is preferably higher than the dopant concentration of the anode-side region from the viewpoint of the properties of injecting carriers into the emitting layer. It is preferable that the concentration in the high concentration region be a concentration at which the maximum efficiency is obtained when fabricating the device at a uniform concentration.
In particular, when the difference (ΔIp) in ionization potential between the luminescent dopant and the host compound satisfies the following condition, and the concentration of each concentration region is 30 wt% or less, the efficiency is further increased by changing the concentration region according to the invention.

$$-0.4\ eV \leq \Delta Ip \leq 0.4\ eV$$

$\Delta Ip = Ip(dopant) - Ip(host\ compound)$

In the device configuration according to the invention, the hole barrier is smaller than the electron barrier so that the hole injecting properties are higher than the electron injecting properties, as described above. Therefore, the above expression indicates the condition in which the current efficiency improvement effect significantly occurs. A more preferred condition is as follows.

$$-0.3\ eV \leq \Delta Ip \leq 0.3\ eV$$

The ionization potential may be measured using a commercially available atmospheric photoelectron spectroscope "AC-1" or the like.
When emission is of blue type, particularly the triplet state contributes to emission, the difference in optical energy gap between the host compound and the dopant compound tends to become smaller. In some cases, the dopant may have a wider optical energy gap. In particular, a heavy metal complex may exhibit an ionization potential higher than that of the host compound due to its structural stability and reactivity. Specifically, the function of stopping (accumulating) holes in the emitting layer may become weak. In order to improve such a hole accumulation effect, when including a hole transporting layer, it is preferable to provide a mixed layer of the hole transporting layer and the host material between the emitting layer and the anode or to use a non-luminescent dopant. As a result, light emitting stability is improved.

As examples of the heavy metal contained in the dopant of the invention, Ir, Pt, Pd, Ru, Rh, Mo, and Re can be given. As examples of the ligand to the heavy metal, a ligand which is coordinated or bonded to a metal at C or N (CN ligand) and the like can be given. As specific examples of the ligand, the following ligands can be illustrated.

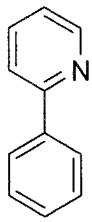
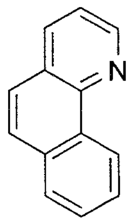
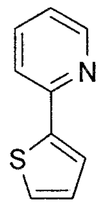
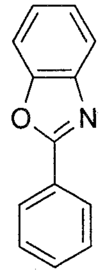

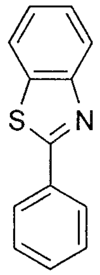
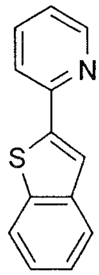
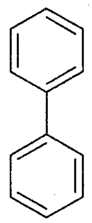

Ligands preferably have a fluorine atom. For example, the following ligands can be given.

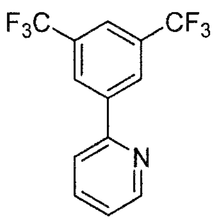
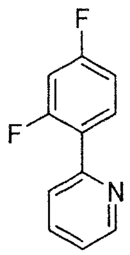
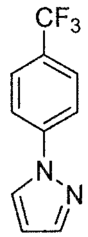

As the host materials of the emitting layer, compounds exhibiting excellent thin film formability, such as amine derivatives, carbazole derivatives, oxadiazole derivatives, triazole derivatives, benzoxazole type, benzothiazole type, and benzimidazole type fluorescent whitening agents, metal chelate oxanoid compounds, and styryl compounds, can be given.

A host compound is preferably an organic compound having at least one carbazolyl group. As specific examples of such a compound, the compounds described in Japanese Patent Application No. 2003-387855 and US6863997B2 can be given. As preferable structure skeletons, the skeletons described in claims 1 and 11 of US6863997B2 can be given. As more preferable compounds, the compounds described in claims 24 and 26 of US6863997B2 can be given.

The triplet level energy of a host compound is preferably greater than the triplet level energy of a dopant. This allows the energy of the host compound to efficiently transfer to the dopant so that a luminous efficiency is enhanced. As specific examples of the host compound, the following carbazolyl-group-containing organic compounds can be given.

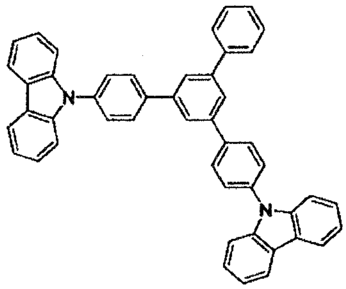
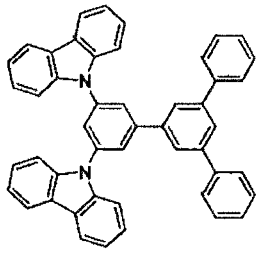
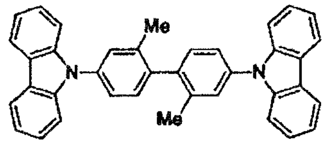

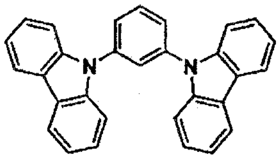
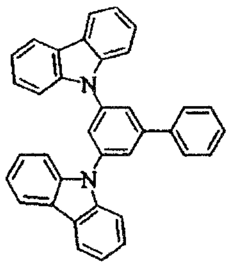
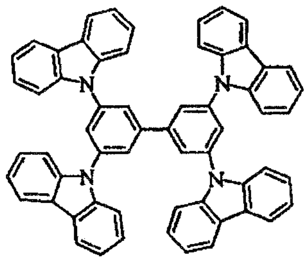

wherein Me indicates a methyl group.

The materials for the hole injecting layer and the hole transporting layer are not particularly limited. A known organic material for an organic EL device may be used. As specific examples of such a material, amine derivatives, stilbene derivatives, silazane derivatives, polysilane, aniline copolymers, and the like can be given.

As the materials for the electron injecting layer and the electron transporting layer, compounds having a carbazolyl group and a hetero ring, and aluminum chelate complexes, which have been hitherto used, can be given. In particular, the compounds described in Japanese Patent application No. 2002-299810 and Japanese Patent application No. 2004-064004 can be preferably given.

As examples of the compound having a carbazolyl group and a hetero ring, the following compounds can be illustrated.

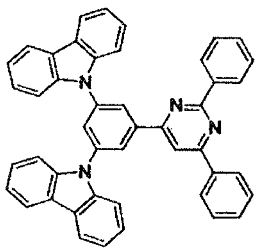
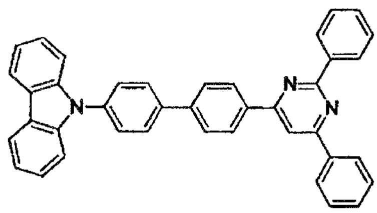
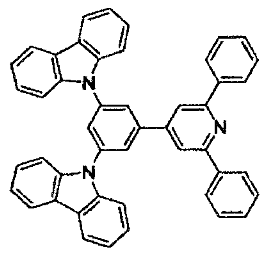

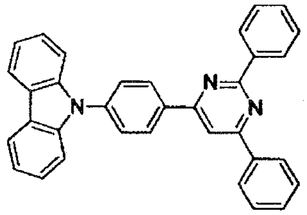
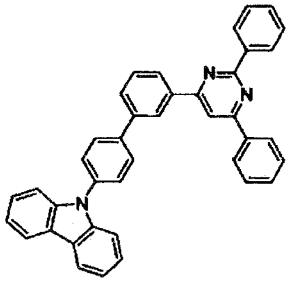
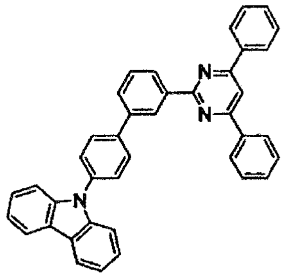

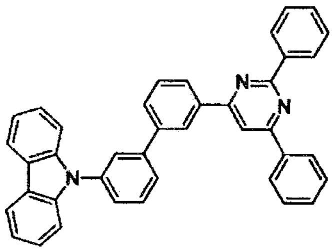
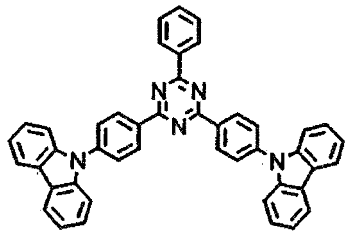

As examples of the aluminum chelate complex, the compounds of the following formula (1) can be illustrated.

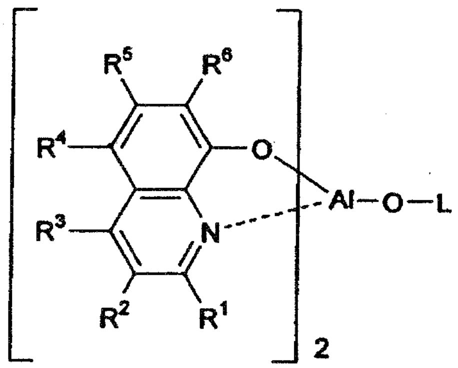
(1)

wherein $R^1$ is an alkyl group, oxy group or amino group; $R^2$ and $R^3$ are each a hydrogen atom, alkyl group, oxy group or amino group; and $R^4$, $R^5$ and $R^6$ may be each selected from cyano, halogen, a-haloalkyl, α-haloalkoxy, amide, or sulfonyl, and L is represented by the following formula (2) or (3).

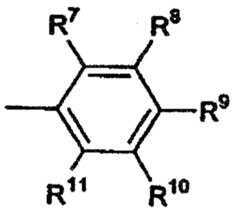

(2)

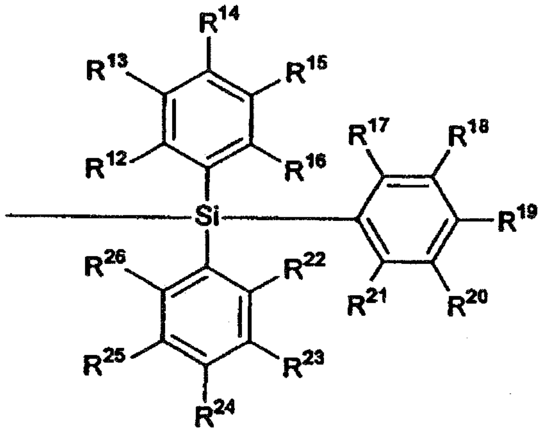

(3)

wherein $R^7$ to $R^{26}$ are each a hydrogen atom or a hydrocarbon group.

As specific examples of the aluminum chelate complex, the following compounds can be illustrated.

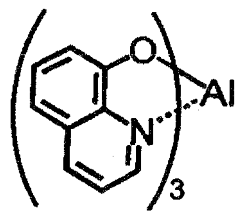

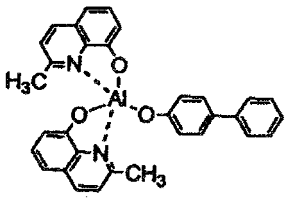

The organic EL device according to the invention is preferably supported by a substrate. The material for the substrate is not particularly limited. A known material used for an organic EL device such as glass, transparent plastic, or quartz may be used.

As the material for the anode, a metal, alloy, or electric conductive compound, or a mixture of these materials having a work function as large as 4 eV or more is preferably used. As specific examples of such a material, metals such as Au and dielectric transparent materials such as CuI, ITO, $SnO_2$, and ZnO can be given.
The anode may be formed by forming a thin film of the above-mentioned material by deposition, sputtering method, or the like. When outcoupling light from the emitting layer through the anode, it is preferable that the anode have a transparency of more than 10%. The sheet resistance of the anode is preferably several hundred ohm/square or less. The thickness of the anode is usually 10 nm to 1 micron, and preferably 10 to 200 nm, although the thickness varies depending on the material.

As the material for the cathode, a metal, alloy, or electric conductive compound, or a mixture of these materials having a work function as small as 4 eV or less is preferably used. As specific examples of such a material, sodium, lithium, aluminum, magnesium/silver mixture, magnesium/copper mixture, $Al/Al_2O_3$, indium, and the like can be given.
The cathode may be formed by forming a thin film of the above-mentioned material by deposition, sputtering method, or the like. When outcoupling light from the emitting layer through the cathode, it is preferable that the cathode have a transparency of more than 10%. The sheet resistance of the cathode is preferably several hundred ohm/square or less.

The thickness of the cathode is usually 10 nm to 1 micron, and preferably 50 to 200 nm, although the thickness varies depending on the material.

In the organic EL device according to the invention, an inorganic material may be added to the hole transporting layer and the electron injecting layer as required in order to further increase the current or luminous efficiency. Preferably, an inorganic material may be used in the hole injecting or transporting layer. In order to further increase the current (luminous) efficiency, an inorganic material may be used between the electron transporting layer and the metal cathode. As specific examples of the inorganic material, fluorides and oxides of alkali metals such as Li, Mg, and Cs can be given.

EXAMPLES

Example 1

Fabrication of organic EL device

A glass substrate (manufactured by Geomatics Co.), measuring 25 mm x 75 mm x 1.1 mm thick with an ITO transparent electrode was subjected to ultrasonic cleaning in isopropyl alcohol for 5 minutes and then to UV ozone cleaning for 30 minutes. The cleaned glass substrate with transparent electrode lines was mounted on a substrate holder in a vacuum deposition apparatus. First, a 100 nm thick film was formed of a hole injecting material of HIM illustrated below by resistance heating deposition on the surface where the transparent electrode lines were formed so as to cover the transparent electrode. This film functioned as a hole injecting layer (HIL). After the formation of HIM film, a 10 nm thick hole transporting layer (HTL) was formed of HTM illustrated below by resistance heating deposition.

A host compound (Host illustrated below, Ip=6.0 eV, $Eg^s$=3.21 eV, $Eg^T$=2.89 eV) and a dopant (complex D illustrated below, Ip=6.3 eV, $Eg^T$=2.75 eV) were co-deposited by resistance heating to form a 30 nm thick film thereon. At this time, an anode-side region was formed to a 5 nm thickness at a certain concentration thereof by controlling a film-formation rate; an internal region was further formed to a 5 nm thickness at a certain concentration thereof; and then a 20 nm thick cathode-side region was further formed at a certain concentration thereof. An emitting layer was formed of the anode-side region, the internal region and the cathode-side region.

After the formation of the emitting layer, ETM illustrated below was deposited by resistance heating to form a 25 nm thick electron transporting layer (ETL). A 5 nm thick Alq layer (electron injecting layer) (EIL) was formed thereon. Thereafter, a 0.1 nm thick electron injecting electrode (cathode) was formed of LiF at a film-formation rate of 1 Å/minute. A metal Al was deposited on the LiF layer to form a 130 nm thick metal cathode, thereby fabricating an organic EL device.

The ionization potential of the host compound and the dopant was measured using an atmosphere ultraviolet photoelectron spectrometer "AC-1" (manufactured by Riken Keiki Co., Ltd.) An $Eg^s$ value was obtained from measurement results of absorption spectrum of a toluene dilute solution of the host compound. An $Eg^T$ value was determined in the above-mentioned method.

In this example, the dopant concentration of each region was substantially constant, and the dopant concentration was calculated from the film-formation rate. The thickness-direction concentration distribution of the dopant concentration can be measured by XPS (X-ray photoelectron spectroscopy). The results were shown in Table 1.

Note that the values (%) of brackets in the emitting layer (ELM) section in Table indicate a dopant concentration (wt%) of each region.

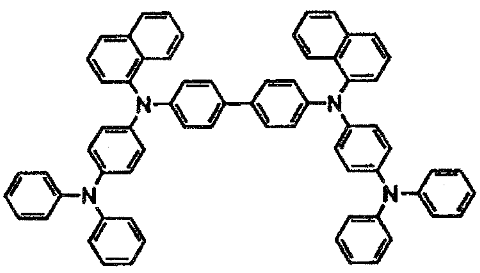

HIM

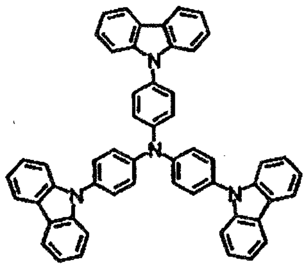

HTM

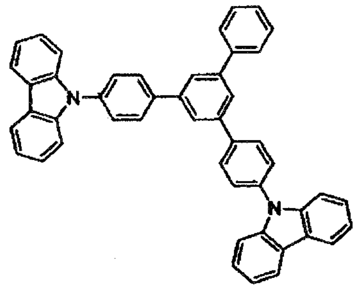

HOST

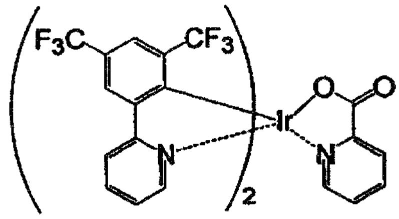

Complex D

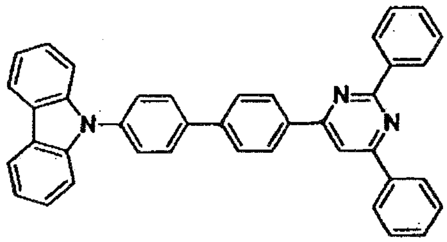

ETM

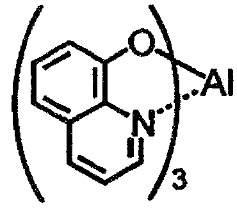

Alq

Evaluation of organic EL device

Luminance, efficiency and chromaticity of the organic EL device obtained were measured under the condition of applying a certain DC voltage to calculate a current efficiency (=(luminance)/(current density)) at a luminance of about 100 cd/$m^2$.
The results were shown in Table 1. In Table, V is an applied DC voltage. J is a current density, L is a luminance, and L/J indicates a current efficiency. k is a luminous efficiency. E.Q.E. is an external quantum efficiency and the greater value thereof indicates higher performance in the same color series. λmax is a peak wavelength of an EL spectrum. CIE(x, y) is a chromaticity.

Comparative Example 1

An organic EL device was fabricated and then evaluated in the same manner as in Example 1 except that the dopant concentrations of the regions were the same. The results were shown in Table 1.

Examples 2 to 11

Organic EL devices were fabricated and then evaluated in the same manner as in Example 1 except that the thicknesses and dopant concentrations of the regions in an emitting layer were changed as shown in Tables 1 to 6. The results were shown in Tables 1 to 6.

Comparative Examples 2 to 4

Organic EL devices were fabricated and then evaluated in the same manner as in Comparative Example 1 except that the thicknesses and dopant concentrations of the regions in an emitting layer were changed as shown in Tables 1 to 6. The results were shown in Tables 1 to 6.
Table 1

| | HIL | HTL | EML(Av.7.8%) Thickness(nm) | | | ETL | EIL | V (V) | J (mA/cm$^2$) | L (cd/m$^2$) | L/J (cd/A) | k (lm/W) | E.Q.E. (%) | λmax (nm) | CIE (x) | CIE (y) |
|---|---|---|---|---|---|---|---|---|---|---|---|---|---|---|---|---|
| | Thickness (nm) | Thickness (nm) | HOST:Complex D (7.1%) Thickness(nm) | HOST:Complex D (12%) Thickness(nm) | HOST:Complex D (7.1%) Thickness(nm) | Thickness (nm) | Thickness (nm) | | | | | | | | | |
| Ex. 1 | 100 | 10 | 5 | 5 | 20 | 25 | 5 | 6.8 | 0.3 | 101 | 34 | 15 | 14.8 | 475 | 0.176 | 0.396 |
| Ex. 2 | 100 | 10 | 20 | 5 | 5 | 25 | 5 | 6.7 | 0.4 | 111 | 32 | 15 | 14.0 | 475 | 0.176 | 0.397 |
| Ex. 3 | 100 | 10 | 12.5 | 5 | 12.5 | 25 | 5 | 6.7 | 0.3 | 107 | 36 | 17 | 15.9 | 475 | 0.177 | 0.391 |
| Com.Ex. 1 | 100 | 10 | 30 | | | 25 | 5 | 6.8 | 0.4 | 115 | 28.6 | 13 | 12.80 | 475 | 0.175 | 0.388 |

Table 2

| | HIL | HTL | EML(Av.6.5%) Thickness(nm) | | | ETL | EIL | V (V) | J (mA/cm$^2$) | L (cd/m$^2$) | L/J (cd/A) | k (lm/W) | E.Q.E. (%) | λmax (nm) | CIE (x) | CIE (y) |
|---|---|---|---|---|---|---|---|---|---|---|---|---|---|---|---|---|
| | Thickness (nm) | Thickness (nm) | HOST:Complex D (5%) Thickness(nm) | HOST:Complex D (14%) Thickness(nm) | HOST:Complex D (5%) Thickness(nm) | Thickness (nm) | Thickness (nm) | | | | | | | | | |
| Ex. 4 | 100 | 10 | 20 | 5 | 5 | 25 | 5 | 6.3 | 0.4 | 108 | 30.9 | 15.3 | 13.9 | 475 | 0.174 | 0.387 |
| Ex. 5 | 100 | 10 | 5 | 5 | 20 | 25 | 5 | 6.9 | 0.40 | 103 | 25.7 | 12 | 11.4 | 475 | 0.171 | 0.397 |
| Ex. 6 | 100 | 10 | 20 | 5 | 5 | 25 | 5 | 6.5 | 0.35 | 98 | 27.9 | 13 | 12.3 | 475 | 0.171 | 0.401 |
| Ex. 7 | 100 | 10 | 12.5 | 5 | 12.5 | 25 | 5 | 6.7 | 0.4 | 104 | 25.9 | 12 | 11.6 | 475 | 0.1719 | 0.3911 |
| Com.Ex. 2 | 100 | 10 | 30 | | | 25 | 5 | 6.7 | 0.5 | 100 | 20 | 9 | 8.8 | 475 | 0.174 | 0.402 |

Table 3

| | HIL | HTL | EML(Av.6.5%) Thickness(nm) | | | ETL | EIL | V (V) | J (mA/cm$^2$) | L (cd/m$^2$) | L/J (cd/A) | k (lm/W) | E.Q.E. (%) | λmax (nm) | CIE (x) | CIE (y) |
|---|---|---|---|---|---|---|---|---|---|---|---|---|---|---|---|---|
| | Thickness (nm) | Thickness (nm) | HOST:Complex D (5.5%) Thickness(nm) | HOST:Complex D (14%) Thickness(nm) | HOST:Complex D (3%) Thickness(nm) | Thickness (nm) | Thickness (nm) | | | | | | | | | |
| Ex. 8 | 100 | 10 | 20 | 5 | 5 | 25 | 5 | 6.5 | 0.4 | 101 | 28.0 | 13.9 | 12.4 | 475 | 0.174 | 0.387 |

Table 4

| | HIL | HTL | EML(Av.6.5%) Thickness(nm) | | | ETL | EIL | V (V) | J (mA/cm$^2$) | L (cd/m$^2$) | L/J (cd/A) | k (lm/W) | E.Q.E. (%) | λmax (nm) | CIE (x) | CIE (y) |
|---|---|---|---|---|---|---|---|---|---|---|---|---|---|---|---|---|
| | Thickness (nm) | Thickness (nm) | HOST:Complex D (3.5%) Thickness(nm) | HOST:Complex D (15%) Thickness(nm) | HOST:Complex D (10%) Thickness(nm) | Thickness (nm) | Thickness (nm) | | | | | | | | | |
| Ex. 9 | 100 | 10 | 20 | 5 | 5 | 25 | 5 | 6.7 | 0.3 | 110 | 33.3 | 15.6 | 13.0 | 475 | 0.170 | 0.378 |

Table 5

| | HIL | HTL | EML(Av.11%) Thickness(nm) | | | ETL | EIL | V (V) | J (mA/cm$^2$) | L (cd/m$^2$) | L/J (cd/A) | k (lm/W) | E.Q.E. (%) | λmax (nm) | CIE (x) | CIE (y) |
|---|---|---|---|---|---|---|---|---|---|---|---|---|---|---|---|---|
| | Thickness (nm) | Thickness (nm) | HOST:Complex D (5%) Thickness(nm) | HOST:Complex D (14%) Thickness(nm) | HOST:Complex D (5%) Thickness(nm) | Thickness (nm) | Thickness (nm) | | | | | | | | | |
| Ex. 10 | 100 | 10 | 5 | 20 | 5 | 25 | 5 | 6.7 | 0.30 | 112 | 37.3 | 17 | 16.3 | 475 | 0.176 | 0.407 |
| Com.Ex. 3 | 100 | 10 | 30 | | | 25 | 5 | 6.6 | 0.3 | 107 | 35.7 | 16.9 | 15.5 | 475 | 0.1752 | 0.4071 |

Table 6

| | HIL | HTL | EML(Av.8%) Thickness(nm) | | | ETL | EIL | V (V) | J (mA/cm$^2$) | L (cd/m$^2$) | L/J (cd/A) | k (lm/W) | E.Q.E. (%) | λmax (nm) | CIE (x) | CIE (y) |
|---|---|---|---|---|---|---|---|---|---|---|---|---|---|---|---|---|
| | Thickness (nm) | THickness (nm) | HOST:Complex D (5%) Thickness(nm) | HOST:Complex D (14%) Thickness(nm) | HOST:Complex D (5%) Thickness(nm) | Thickness (nm) | Thickness (nm) | | | | | | | | | |
| Ex. 11 | 100 | 10 | 10 | 10 | 10 | 25 | 5 | 6.7 | 0.35 | 103 | 29.4 | 14 | 13.0 | 475 | 0.173 | 0.397 |
| Com.Ex. 4 | 100 | 10 | 30 | | | 25 | 5 | 6.8 | 0.4 | 110 | 28.9 | 13 | 12.86 | 475 | 0.175 | 0.388 |

The results revealed that the devices of Examples realized a higher current efficiency than the devices of Comparative Examples which have the same emission color.
A phosphorescent device may need greater concentration than a conventional fluorescent device in order to realize a high current efficiency (L/J (cd./A)) and a high luminous efficiency (k (lm./W)). However, the devices of Examples in which the doping quantities are the same can realize a high current efficiency and high luminous efficiency.

Industrial Applicability

The organic EL device of the invention can be used for a flat luminescent body for wall hanging TVs, a lighting source such as back light for displays and so on.

## Claims

**1.** An organic electroluminescent device comprising:

an anode and a cathode, and
an emitting layer comprising an anode-side region, an internal region and cathode-side region provided between the anode and the cathode;

each of the regions comprising a host compound of an organic material and a dopant of a metal complex containing a heavy metal and exhibiting light emitting properties originated from a triplet state;
the dopant concentration of the internal region being higher than the dopant concentrations of the anode-side region and the dopant concentration of the cathode-side region.

**2.** The organic electroluminescent device according to claim 1 wherein the triplet energy gap of the metal complex is 2.65 eV or more.

**3.** The organic electroluminescent device according to claim 1 or 2 wherein the dopant concentration of the anode-side region and the dopant concentration of the cathode-side region are different.

**4.** The organic electroluminescent device according to claim 3 wherein the dopant concentration of the cathode-side region is higher than the dopant concentration of the anode-side region.

**5.** The organic electroluminescent device according to any one of claims 1 to 4 wherein the dopant concentration of the internal region is 30 wt% or less.

**6.** The organic electroluminescent device according to any one of claims 1 to 5 wherein the difference between the dopant concentration of the internal region, and the dopant concentration of the anode-side region or the cathode-side region having a lower dopant concentration is 3 to 15 wt%.

**7.** The organic electroluminescent device according to any one of claims 1 to 6 wherein the dopant concentration discontinuously changes between the anode-side region, the internal region, and the cathode-side region.

**8.** The organic electroluminescent device according to any one of claims 1 to 7 wherein the anode-side region and the cathode-side region are regions with a thickness of 5 nm or more from the interface between the anode and the cathode, respectively.

**9.** The organic electroluminescent device according to any one of claims 1 to 7 further comprising a hole transporting layer provided between the emitting layer and the anode, or an electron transporting layer provided between the emitting layer and the cathode;
the anode-side region and the cathode-side region being regions with a thickness of 5 nm or more from the interface between the hole transporting layer or the electron transporting layer and the emitting layer, respectively.

**10.** The organic electroluminescent device of any one of claims 1 to 9 emitting light containing a wavelength component of 350 nm or more and 450 nm or less.

FIG. 1

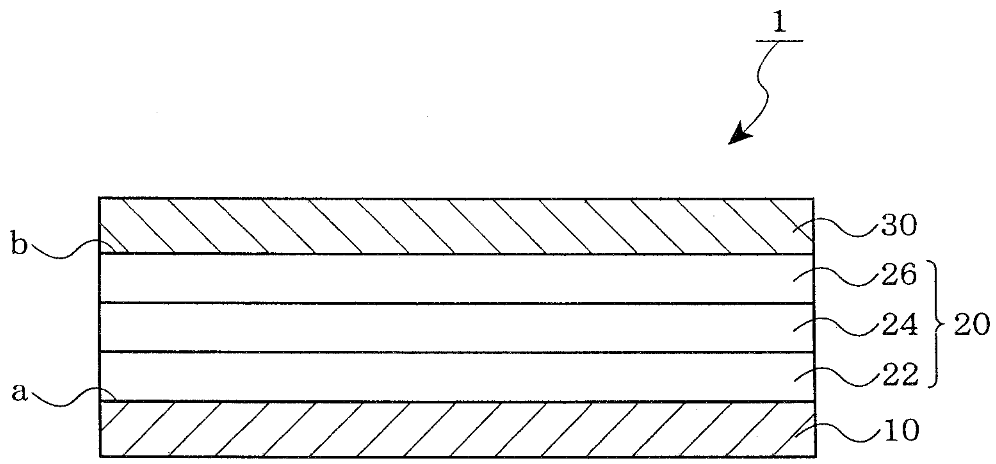

FIG. 2

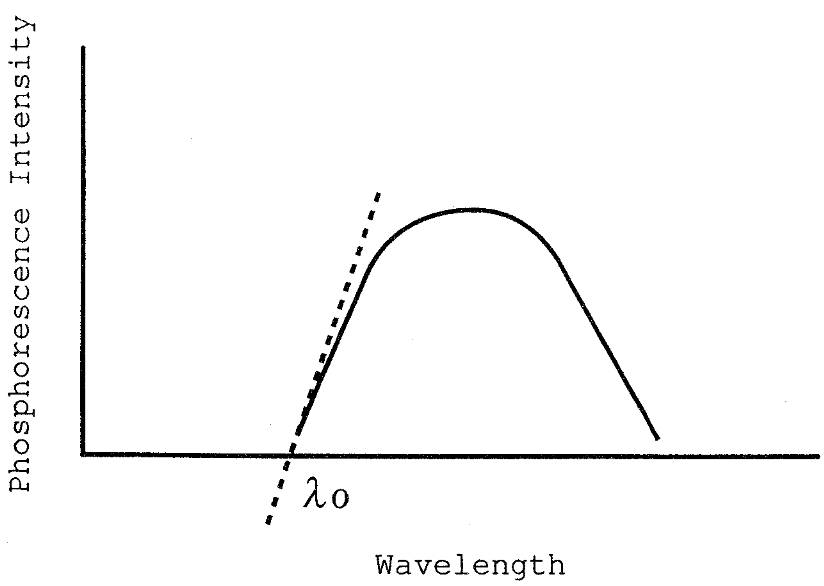

FIG.3

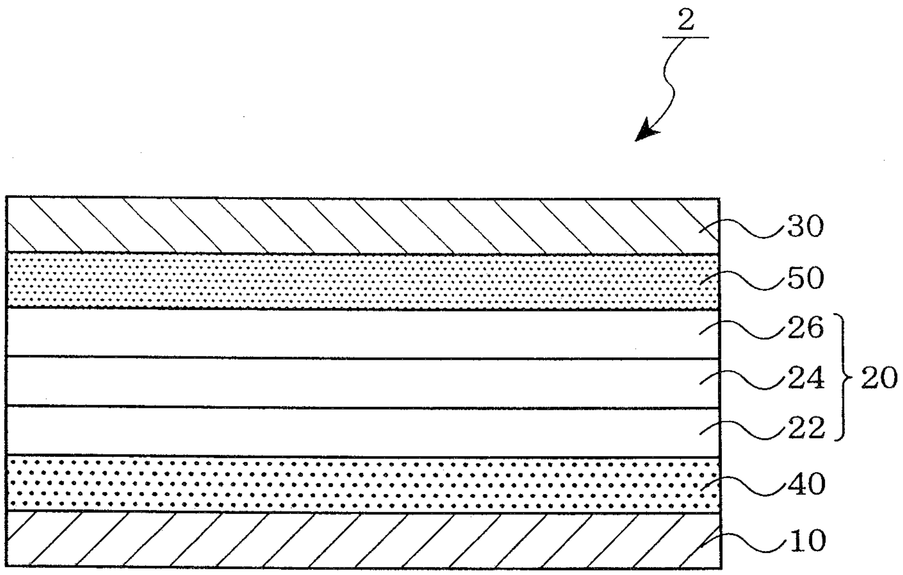

## INTERNATIONAL SEARCH REPORT

International application No. PCT/JP2006/313100

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
*H01L51/50*(2006.01)i, *C09K11/06*(2006.01)i

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-108730 B1 (TDK Corp.), 21 April, 2005 (21.04.05), Par. Nos. [0081] to [0101]; Figs. 9, 10 (Family: none) | 1-10 |
| Y | JP 2004-6102 B1 (Canon Inc.), 08 January, 2004 (08.01.04), Par. Nos. [0010] to [0012] (Family: none) | 1-10 |
| Y | WO 02/091814 A2 (THE TRUSTEES OF PRINCETON UNIVERSITY), 21 November, 2002 (21.11.02), Full text; all drawings & US 2002/0197511 A1 & EP 139-962 A2 & KR 2004012843 A & AU 2002305548 A1 & CN 1543659 A & IN 200301950 P1 | 1-10 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 July, 2006 (31.07.06) | 15 August, 2006 (15.08.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 63295695 A
- JP 2005100767 A
- US 20050046337 A1
- JP 2003387855 A
- US 6863997 B2
- JP 2002299810 A
- JP 2004064004 A


### Non-patent literature cited in the description


- **T. TSUTSUI.** *Jpn. J. Appl. Phys.,* 1999, vol. 38, L1502-L1504
- The World of Photochemistry. 1993, 50